# EUROPÄISCHE PATENTANMELDUNG

(11) **EP 2 296 275 A1**
(43) Veröffentlichungstag der Anmeldung: **16.03.2011**
(21) Anmeldenummer: 10176958.6
(22) Anmeldetag: 15.09.2010
(51) Int. Cl.: H03K 17/94, H03K 17/97, G08C 17/02, G06F 1/26

(54) **Vorrichtung und Verfahren zum Aktivieren eines Geräts und Gerät**

(30) Priorität: 15.09.2009 DE 102009041547
(71) Anmelder: Fraunhofer-Gesellschaft zur Förderung der Angewandten Forschung e.V., 80686 München (DE); IT-Designers GmbH, 73730 Esslingen (DE)
(72) Erfinder: Deubzer, Ottmar, 10405, Berlin (DE); Ulmer, Daniel, 71083, Herrenberg (DE)
(74) Vertreter: Stöckeler, Ferdinand

(57) **Zusammenfassung**

Eine Vorrichtung zum Aktivieren eines Geräts weist ein Schaltelement und eine Einschalteinrichtung, die ausgelegt ist, um ein frequenzselektives Bauelement durch ein elektromagnetisches Signal, das über eine Antenne des Geräts empfangen wird, anzuregen, wodurch eine Betätigung des Schaltelements bewirkt wird, um das Gerät mit einer Leistungsversorgung zu verbinden, wobei die Resonanzfrequenz des frequenzselektiven Bauelementes auf die Frequenz des innerhalb eines vorbestimmten Frequenzbereichs übertragenen Signals abgestimmt ist, auf.

## Beschreibung

Ausführungsbeispiele der Erfindung beziehen sich auf eine Vorrichtung und ein Verfahren zum Aktivieren eines Geräts und ein Gerät. Weitere Ausführungsbeispiele der Erfindung beziehen sich auf ein Konzept zum kabellosen bzw. nicht kabelgebundenen Aktivieren eines elektrischen oder elektronischen Geräts aus dem vollständigen AusZustand mittels elektromagnetischer Strahlung bzw. elektromagnetischer Wellen.

Zahlreiche elektronische Geräte befinden sich im Standby-Betrieb, auch wenn sie nur wenige Minuten am Tag gebraucht werden. Gleichzeitig werden immer mehr Geräte netzwerktauglich, und sie werden vermehrt kabellos, wie beispielsweise über WLAN, angesteuert.

In der Druckschrift US 2004/0264396 A1 wird ein Konzept zur Verminderung des Energieverbrauchs in einem WLAN-Netz beschrieben, bei dem Datenpakete z.B. in einem Puffer eines WLAN-Zugriffspunkts gespeichert werden können, wobei während des Zeitintervalls der Speicherung das WLAN-Endgerät in einen "Stromsparmodus" versetzt oder vollständig ausgeschaltet werden kann.

Ein Aufweck-Trigger, der vorgesehen ist, um den Stromsparmodus zu verlassen und in den Betriebsmodus zu gelangen, kann dabei durch ein bestimmtes Ereignis wie z.B. Erreichen einer Mindestanzahl oder -größe der in den Speicher aufgenommenen Datenpakete ausgelöst werden.

Bei Erscheinen des Aufweck-Triggers können die im Puffer gespeicherten Daten übertragen werden.

In der Druckschrift DE 600 34 684 T2 wird ein mechanischer Vibrator im Nanometerbereich, ein Verfahren zu dessen Herstellung und eine Messvorrichtung, die ihn benutzt, beschrieben. Im Allgemeinen ist der mechanische Vibrator im Nanometerbereich (Nano-Oszillator) geeignet, um hochempfindlich eine Variation bezüglich der Masse des Oszillators und eine Variation eines Feldes, in welchem der Oszillator platziert ist, zu detektieren. Insbesondere können Nano-Oszillatoren als Prüfspitzen zur Realisierung eines sogenannten Scanning-Kraftmikroskops (Scanning Force Microscope) verwendet werden.

In der Druckschrift DE 10 2005 044 615 A1 wird eine fernbedienbare Schaltung mit extrem niedrigem Standby-Stromverbrauch im Mikrowatt-Bereich beschrieben. Mit Hilfe der fernbedienbaren Schaltung ist es möglich, den Standby-Stromverbrauch von stromnetzbetriebenen Geräten bzw. Verbrauchern auf nur wenige 10 Mikrowatt zu reduzieren, wobei dieser Wert durch die Verwendung von leistungslos ansteuerbaren Feldeffekttransistoren (FET) mit extrem geringem Leckstrom bei "zero gate voltage" und der Energieübertragung per Funk, Licht oder Schall erreicht wird. Die an eine/n Antenne/Transducer übertragene Energie soll dabei ausreichen, um einen ultra low power Mikrocontroller zu versorgen, der den o.g. Feldeffekttransistor einer Relaistreiberstufe steuert und einen elektrischen Verbraucher über ein Relais an das Stromnetz anschließt.

Der Nachteil bei dem Konzept aus der DE 10 2005 044 615 A1 ist, dass genügend Energie für den Mikrocontroller von der/dem Antenne/Transducer bereitgestellt werden muss, so dass dieser entscheiden kann, ob einzuschalten ist oder nicht. Außerdem muss die Energie noch für die Steuerung des FETs ausreichen, welcher jedoch entsprechend der DE 10 2005 044 615 A1 nur eine gleichgerichtete Netzspannung schalten kann. Da bei der Gleichrichtung durch die Gleichrichterdioden konstant ein Leckstrom fließt, wird eine Verlustleistung im Standby-Betrieb hervorgerufen.

Ferner wird bei der DE 10 2005 044 615 A1 nicht der Beweis erbracht, ob die übertragene Energie tatsächlich ausreicht, um den Mikrocontroller mit Spannung zu versorgen. Insbesondere wird hierbei der Prototyp mit einer Spannungsquelle und nicht mit einer/einem Antenne/Transducer realisiert.

WO 20091109889 A1 beschreibt ein Verfahren zum Betätigen eines Schalters zwischen einer zu kontrollierenden Vorrichtung und einer Stromversorgung, das die Schritte des Erzeugens eines ersten elektrischen Signals in einer Fernsteuerungseinrichtung und des Umwandelns des ersten elektrischen Signals in elektromagnetische Strahlung (EM) mittels einer ersten transmittierenden Antenne der Fernsteuerungseinrichtung umfasst. Eine erste detektierende Antenne eines Fernsteuerungsschnittstellenmoduls der zu kontrollierenden Vorrichtung detektiert die elektromagnetische Strahlung (EM), um ein zweites elektromagnetisches Signal, das passiv in ein Schalter betätigendes Signal umgewandelt wird, zu erhalten. Das Schalter betätigende Signal wird betätigt, um die zu kontrollierende Vorrichtung zwischen einem Betriebsmodus, in dem während des Betriebs Strom von der Stromversorgung durch die Vorrichtung gezogen wird, und einem passiven Modus, in dem die Vorrichtung vollständig von der Stromversorgung getrennt ist, so dass kein Strom durch die Vorrichtung gezogen wird, umzuschalten. Ferner beschreibt WO 2009/109889 A1 ein System zum Betätigen eines Schalters zwischen einer zu kontrollierenden Vorrichtung und einer Stromversorgung. Es werden außerdem ein Fernsteuerungsschnittstellenmodul und eine Fernsteuerungseinrichtung beschrieben.

US 2006/0030353 A1 stellt eine Vorrichtung und ein Verfahren zum Kontrollieren der Leistung im Ruhezustand in einem mobilen Kommunikationsgerät bereit. Ein Radiokommunikationsgerät mit einer Stromversorgung wandelt ein Radiosignal, das mit einer Antenne empfangen wird, in ein Basisband-Signal unter Verwendung einer Referenz-Schwingungsfrequenz eines spannungsgesteuerten Oszillators um. Ein Radiofrequenzidentifizierungs-(RFID)Tag erzeugt Leistung mittels eines Abfragesignals von einer Basisstation und gibt ein Aufwecksignal aus, das dazu verwendet wird, um zu ermitteln, ob ein Radiosignal empfangen wurde unter Verwendung der erzeugten Leistung. Eine Steuerungseinrichtung steuert die Stromversorgung, um ansprechend auf das Aufwecksignal von dem RFID-Tag das Radiokommunikationsgerät mit Leistung zu versorgen. Dementsprechend kann eine gewisse Menge an Leistungsaufnahme in dem mobilen Kommunikationsgerät verringert werden.

US 2004/0078151 A1 beschreibt ein kabelloses LAN-(WLAN)Radiofrequenzidentifizierungs-(RFID)Tag-System, das Lokalisierungssuche in einem kabellosen LAN (WLAN) ermöglicht, unter Verwendung eines WLAN-Kanals. Störungen mit dem WLAN werden vermieden entweder durch Verwendung eines Schnüffel-Schaltkreises, der dazu ausgebildet ist, um zu ermitteln, dass keine Netzwerkübertragung stattfindet, wobei eine modifizierte Codierungssequenz oder ein Anfangshinweiscode (Präambel) verwendet wird, um standardmäßige WLAN-Empfänger zu veranlassen, die RFID-Tag-Übertragungen zu ignorieren, oder durch Übertragen einer Nachricht mittels eines standardmäßigen WLAN-Signals, das einer Adresse zugewiesen ist, die nicht einem Gerät innerhalb des WLANs zugeordnet ist. Lokalisierungseinheiten (LUs) und eine Mastereinheit (MU) innerhalb des WLANs empfangen die RFID-Tag-Übertragungen und können die Position eines Tags durch Triangulation basierend auf Differenzen zwischen den Signalen, die an den Lokalisierungseinheiten von dem Tag empfangen werden, ermitteln. Die Mastereinheit empfängt die Signalinformation von den Lokalisierungseinheiten und berechnet die Position des Tags. Eine Laufzeitdifferenzmethode (time-difference-of-arrival, TDOA), eine empfangene Signalstärkeanzeigemethode (signal strength indication, RSSI) oder andere Triangulationstechniken können verwendet werden.

Die Aufgabe der vorliegenden Erfindung besteht darin, eine Vorrichtung und ein Verfahren zum selektiven Aktivieren eines Geräts zu schaffen.

Diese Aufgabe wird durch eine Vorrichtung nach Anspruch 1, ein Gerät nach Anspruch 9 und ein Verfahren nach Anspruch 11 gelöst.

Ausführungsbeispiele der Erfindung beziehen sich auf eine Vorrichtung zum Aktivieren eines Geräts, mit folgenden Merkmalen:
einem Schaltelement; und
einer Einschalteinrichtung, die ausgelegt ist, um ein frequenzselektives Bauelement durch ein elektromagnetisches Signal, das über eine Antenne des Geräts empfangen wird, anzuregen, wodurch eine Betätigung des Schaltelements bewirkt wird, um das Gerät mit einer Leistungsversorgung zu verbinden, wobei die Resonanzfrequenz des frequenzselektiven Bauelementes auf die Frequenz des innerhalb eines vorbestimmten Frequenzbereichs übertragenen Signals abgestimmt ist.

Das erfindungsgemäße Konzept ermöglicht vorteilhaft, elektromagnetische Energie aus einem innerhalb eines vorbestimmten Frequenzbereichs, beispielsweise über einen WLAN-Kanal, übertragenen Signal zu nutzen, um frequenzselektiv ein frequenzselektives Bauelement, wie beispielsweise einen Schwingkreis oder einen mechanischen Schwinger, anzuregen bzw. in Schwingungen zu versetzen, wodurch ein Schaltelement betätigt werden kann, um ein Gerät mit einer Leistungsversorgung zu verbinden. Dadurch, dass das frequenzselektive Bauelement sehr selektiv auf bestimmte Frequenzen ansprechen kann, kann das Gerät nur durch Aufwecksignale innerhalb des vorbestimmten Frequenzbereichs (z.B. WLAN-Aufwecksignale) und nicht durch Signale auf anderen Frequenzen aktiviert werden, so dass ein unbeabsichtigtes Aufwecken vermieden werden kann. Ferner kann eine Reduzierung des Energieverbrauchs erreicht werden, indem die Antenne des Geräts mit dem frequenzselektiven Bauelement gekoppelt wird, wenn das Gerät nicht mit einer Leistungsversorgung verbunden ist und die Antenne mit dem Empfänger des Geräts gekoppelt wird, wenn das Gerät mit der Leistungsversorgung verbunden ist.

Ein Vorteil der vorliegenden Erfindung ist, dass die erfindungsgemäße Vorrichtung das Gerät vollständig vom Stromversorgungsnetz trennt, wenn der "Service" (Dienst) des Gerätes nicht benötigt wird. Gleichzeitig ist das Gerät aus diesem vollständigen "Aus"-Modus mit Hilfe der erfindungsgemäßen Vorrichtung auch wieder aktivierbar. Die erfindungsgemäße Vorrichtung ermöglicht es somit, das Gerät vollständig von der Stromversorgung zu trennen, wobei es jedoch aus diesem Zustand dennoch aktivierbar ist.

Ausführungsbeispiele der vorliegenden Erfindung werden nachfolgend anhand der beiliegenden Zeichnungen näher erläutert. Es zeigen:
- Fig. 1: ein Ausführungsbeispiel einer erfindungsgemäßen Vorrichtung;
- Fig. 2: eine Darstellung eines erfindungsgemäßen Nano-Zustandsautomaten; und
- Fig. 3: eine Darstellung eines erfindungsgemäßen WLAN-Spektrums.

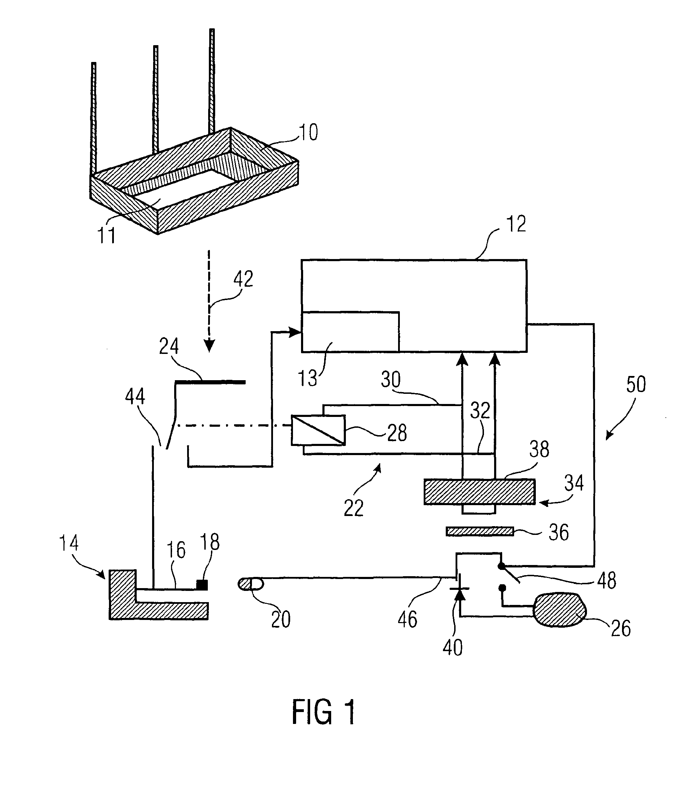

Fig. 1 zeigt ein WLAN-Netz mit einem WLAN-Zugriffspunkt 10 und einem WLAN-Endgerät 12. Dabei kann das WLAN-Netz eine Vielzahl von WLAN-Zugriffspunkten 10 und/oder WLAN-Endgeräten 12 aufweisen.

Im Folgenden wird zunächst jeweils nur ein Gerät beschrieben, wobei die Situation später auf mehrere Geräte (Teilnehmer) übertragen werden kann. Der WLAN-Zugriffspunkt 10 weist einen Sender 11 auf. Das WLAN-Endgerät 12 weist einen Empfänger 13 auf.

Bei dem in Fig. 1 gezeigten Ausführungsbeispiel weist die Vorrichtung zum Aktivieren des WLAN-Endgeräts 12 eine Einschalteinrichtung 14, die aus einem frequenzselektiven Bauelement, wie beispielsweise dem in Fig. 1 gezeigten mechanischen Schwinger 16, einem Permanentmagneten 18 und einer Induktionsspule 20 besteht, auf.

Bei alternativen Ausführungsbeispielen der Erfindung kann das frequenzselektive Bauelement einen Resonator bzw. Schwingkreis, wie beispielsweise einen kapazitivinduktiven elektrischen (LC-)Schwingkreis, aufweisen.

Weiterhin weist bei dem Ausführungsbeispiel gemäß Fig. 1 die Vorrichtung zum Aktivieren eine Schalteinrichtung 22 auf, die ausgelegt ist, um eine Antenne 24 des WLAN-Endgeräts 12 mit dem mechanischen Schwinger 16 zu koppeln, wenn das WLAN-Endgerät 12 nicht mit einer Leistungsversorgung 26 verbunden ist und um die Antenne 24 mit dem Empfänger 13 des WLAN-Endgeräts 12 zu koppeln, wenn das WLAN-Endgerät 12 mit der Leistungsversorgung 26 verbunden ist.

Bei Ausführungsbeispielen der Erfindung weist die Schalteinrichtung 22 ein Relais 28, das zwischen zwei Leistungspotentiale 30 und 32 geschaltet ist, auf. Weiterhin kann bei Ausführungsbeispielen der Erfindung die Leistungsversorgung 26 durch ein Netzteil 34 des WLAN-Endgeräts 12 implementiert sein, wobei das Netzteil 34 mit dem Stromnetz verbunden werden kann. Das Netzteil 34 weist in üblicher Weise einen Transformator 36 und einen Gleichrichter 38, der die Wechselspannung der Leistungsversorgung 26 in eine Gleichspannung umwandelt, auf.

Der mechanische Schwinger 16 der Einschalteinrichtung 14 ist ausgelegt, um ein über die Antenne 24 empfangenes Signal zu nutzen, um ein Schaltelement 40 zu betätigen, um das WLAN-taugliche Gerät 12 mit der Leistungsversorgung 26 zu verbinden.

Bei Ausführungsbeispielen der Erfindung kann das von dem Sender 11 des WLAN-Zugriffspunkts 10 gesendete Signal über einen WLAN-Kanal 42 übertragen und von der Antenne 24 empfangen werden. Der Sender 11 des WLAN-Zugriffspunkts 10 ist ausgelegt, um über den WLAN-Kanal 42 Kommunikationssignale entsprechend eines WLAN-Protokolls wie herkömmlich und zusätzlich auf die erfindungsgemäße Weise von diesen verschiedene Aufwecksignale zu senden. Dabei können die Aufwecksignal Impulse mit einer maximalen möglichen Ausgangsleistung des WLAN-Zugriffspunkts 10 darstellen.

Wenn das WLAN-taugliche Gerät 12 ausgeschaltet ist, d.h. nicht mit der Leistungsversorgung 26 verbunden ist, wird ein mit der Antenne 24 empfangenes Aufwecksignal über einen Kontakt 44 des Relais 28 an den mechanischen Schwinger 16 weitergeleitet. Die Resonanzfrequenz des mechanischen Schwingers 16 ist dabei auf die Frequenz des Aufwecksignals abgestimmt.

Bei alternativen Ausführungsbeispielen der Erfindung, bei denen das frequenzselektive Bauelement einen Resonator bzw. Schwingkreis aufweist, kann auch die Resonanzfrequenz des Resonators/Schwingkreises auf die Frequenz des Aufwecksignals abgestimmt werden.

Durch die Antenne 24 wird das Aufwecksignal in elektrische Signale umgewandelt, durch die der mechanische Schwinger 16 in Schwingungen versetzt wird. Dadurch bewegt sich der an dem freien Ende des mechanischen Schwingers 16 angeordnete Permanentmagnet 18, der bezüglich der Induktionsspule 20 derart angeordnet ist, dass bei einer Bewegung des Permanentmagneten 18 ein Strom in die Induktionsspule 20 induziert wird. Die Induktionsspule 20 ist mit dem Steueranschluss 46 des Schaltelements 40 verbunden. Durch Anlegen des induzierten Stroms an den Steueranschluss 46 des Schaltelements 40 wird das Schaltelement 40 betätigt, was die Leistungsversorgung 26 mit dem Netzteil 34 des WLAN-Endgeräts 12 verbindet.

Bei Ausführungsbeispielen der Erfindung besteht der mechanische Schwinger 16 aus einem Nano-Oszillator (bzw. Nano-Resonator), der einen einseitig eingespannten mechanischen Schwinger (Cantilever) aufweist. Der mechanische Schwinger kann eine hohe Güte aufweisen, was ermöglicht, dass das Schaltelement 40 sehr selektiv bezüglich der Frequenz anspricht. Als Schaltelement 40 kann ein geeignetes Schaltelement verwendet werden, das in der Lage ist, durch den kleinen aus den mechanischen Schwingungen gewonnenen Strom einen großen Strom, der durch die Leistungsversorgung 26 bereitgestellt wird, zu schalten.

Bei Ausführungsbeispielen der Erfindung kann das WLAN-Endgerät 12 eine Ausschalteinrichtung 50 aufweisen, die einen Schalter 48 umfasst, der mit dem WLAN-Endgerät 12 verbunden ist, um die Leistungsversorgung 26 von dem WLAN-Endgerät 12 durch Unterbrechen des Stromkreises zu trennen.

Ein beispielhafter Betrieb wird im folgenden anhand eines WLAN-Zugriffspunkts 10 und einer Mehrzahl von WLAN-Endgeräten 12 erläutert.

Es wird von einem Ausgangszustand ausgegangen, in dem das WLAN-Endgerät 12 deaktiviert ist und 0 Watt verbraucht. Zunächst sendet der WLAN-Zugriffspunkt 10 auf der WLAN-Frequenz Impulse mit maximal möglicher Ausgangsleistung, und über den WLAN-Kanal 42 gelangt die elektromagnetische Energie zu allen WLAN-Endgeräten 12 im Umkreis. Dann empfängt die Antenne 24 des jeweiligen WLAN-Endgeräts 12 die Signale.

Im ausgeschalteten Zustand, d.h. wenn das WLAN-Endgerät 12 nicht mit der Leistungsversorgung 26 verbunden ist, leitet der Relais-Kontakt 44 das empfangene Signal an die Einschalteinrichtung 14 weiter, so dass der mechanische Schwinger 16 in Schwingungen versetzt wird.

Dadurch bewegt sich der Permanentmagnet 18, der am freien Ende des Nano-Resonators (Cantilever) angeordnet ist, wobei die Resonanzfrequenz des Nano-Resonators genau auf die WLAN-Frequenz abgestimmt ist, bezüglich der Induktionsspule 20 derart, dass ein Strom in die Induktionsspule 20 induziert wird. Mit Hilfe dieses induzierten Stroms wird das Schaltelement 40 gezündet, das die Leistungsversorgung 26 (z.B. 230 V-Netz) zum Netzteil 34 des WLAN-Endgeräts 12 durchschaltet.

Das Relais 28, das nun über die Leistungspotenziale 30 und 32 mit der Leistungsversorgung 26 verbunden ist, schaltet nun derart, dass das von der Antenne 24 empfangene Signal jetzt nicht mehr an die Einschalteinrichtung 14, sondern an den konventionellen Empfänger 13 des WLAN-Endgeräts 12 weitergeleitet wird.

Jetzt sind alle bisher deaktivierten WLAN-Endgeräte 12 im Umkreis des WLAN-Zugriffspunkts 10 in einem Hörzustand, d.h. sie können Nachrichten, die über das WLAN-Protokoll übertragen werden, mithören. Daraufhin kann der WLAN-Zugriffspunkt 10 mit Hilfe des WLAN-Protokolls, das eine Identifikation der anzusprechenden WLAN-Endgeräte 12 enthält, allen aufgewachten Teilnehmern mitteilen, welcher Teilnehmer gemeint war, wobei sich schließlich die nicht angesprochenen Teilnehmer mit Hilfe der Ausschalteinrichtung 50 wieder schlafen legen können.

Insbesondere kann dabei obiges Abschaltverhalten beispielsweise über ein WLAN-Protokoll definiert werden. Im Normalbetrieb stellt das WLAN-Protokoll (z.B. IEEE80211) für jeden am Netz teilnehmenden Knoten bzw. Teilnehmer eine eindeutige Adresse zur Verfügung. Wenn der WLAN-Zugriffspunkt 10 feststellt, dass ein Endgerät 12 mit einer solchen Adresse nicht mehr benötigt wird, so kann er eine Nachricht über den WLAN-Kanal 42 verschicken, mit dem Inhalt "Gerät mit der Adresse xy; bitte abschalten!" Ein Mikrocontroller in den Geräten 12 wertet diese Nachricht aus. Nur das Gerät 12 mit der angesprochenen Adresse führt dann die Aktion durch, indem z.B. die Zuleitung zum Schaltelement 40 unterbrochen wird.

Der WLAN-Zugriffspunkt 10 ist hierbei ausgelegt, um über das WLAN-Protokoll einen Abschaltbefehl an das WLAN-taugliche Gerät 12 zu senden. Bei Ausführungsbeispielen der Erfindung wird das Abschaltsignal bzw. der Abschaltbefehl gemäß dem WLAN-Protokoll zu dem WLAN-tauglichen Gerät 12 übertragen, wenn das WLAN-taugliche Gerät 12 nicht mehr benötigt wird.

Im Allgemeinen kann die Aktivierung des Endgeräts 12 beispielsweise durch eine selbsthaltende Schaltung erfolgen. Beim Abschalten wird die Selbsthaltung aufgehoben. Alternativ zur Selbsthaltung kann ein bistabiles Schaltelement eingesetzt sein, das durch einen Abschaltbefehl in den Zustand "aus" geschaltet wird.

In diesem Zusammenhang wird auch auf die DE 10 2007 028 180 A1 verwiesen.

Zusammenfassend hat jedes Endgerät 12 einen Mechanismus, der es ihm erlaubt, über einen im Mikrocontroller deklarierten Befehl, sich selbst stromlos zu schalten. Diese Stromlosigkeit kann dann durch ein Verfahren zum Aktivieren des WLAN-tauglichen Geräts 12, wie z.B. einen Einschaltvorgang über eine Auswertung per Software in Zusammenarbeit mit dem mechanischen Schwinger 16, wie später genauer beschrieben, aufgehoben werden.

Solange nicht die speziellen Impulse auf dem WLAN-Kanal 42 anliegen, kann der WLAN-Zugriffspunkt 10 mit gewünschten Teilnehmern kommunizieren, ohne dass die anderen Geräte aufwachen.

Obwohl das in Fig. 1 gezeigte Ausführungsbeispiel anhand eines WLAN-Netzes mit einem WLAN-Zugriffspunkt 10 und einem WLAN-tauglichen Gerät (WLAN-Endgerät 12) beschrieben wurde, kann die im Vorhergehenden beschriebene Vorgehensweise auch mit einem anderen (drahtlosen) Netzwerk, bei dem elektromagnetische Wellen zwischen einem Sender (Zugriffspunkt) und einem Empfänger (Endgerät) übertragen werden, verwirklicht werden. Hierbei kann das drahtlose Netzwerk beispielsweise ein WLAN oder ein WPAN (wireless personal area network, drahtloses persönliches Netzwerk) sein. Ferner kann der Sender beispielsweise als WLAN-Zugriffspunkt, als WPAN-Zugriffspunkt oder als Fernsteuerung (Handgerät) ausgebildet sein, während der Empfänger (Endgerät) beispielsweise als WLAN-taugliches Gerät, als WPANtaugliches Gerät oder als ferngesteuertes Gerät ausgebildet sein kann. Darüber hinaus kann ein vorbestimmter Frequenzbereich des zwischen dem Zugriffspunkt und dem Endgerät übertragenen Signals beispielsweise ein WLAN-Kanal oder ein WPAN-Kanal (wie z.B. gemäß dem Bluetooth-Standard) sein.

Die erfindungsgemäße Technologie stellt sicher, dass bei WLAN-Endgeräten mit einem 230 V-Anschluss der Standby-Energieverbrauch auf 0 Watt reduziert werden kann, wenn das Endgerät nicht benötigt wird. Zur Reaktivierung des Geräts kann dabei die durch WLAN übertragene elektromagnetische Energie verwendet werden. Ferner ermöglicht das erfindungsgemäße Konzept vorteilhaft, die elektromagnetische Energie aus einem über einen WLAN-Kanal übertragenen Signal zu nutzen, um ein frequenzselektives Bauelement, wie beispielsweise einen Nano-Resonator, der durch eine sehr schmalbandige Resonanzfrequenz ausgezeichnet ist, anzuregen bzw. in mechanische Schwingungen zu versetzen, wodurch frequenzselektiv die Betätigung eines Schaltelements bewirkt werden kann, so dass das Endgerät aktiviert werden kann. Durch die Resonanz kann das frequenzselektive Bauelement, wie beispielsweise der Nano-Resonator, genügend Energie aufnehmen, um direkt Wechselspannung der Leistungsversorgung schalten zu können.

In anderen Worten, diesem Patent liegt die Idee zugrunde, den Energieeintrag aus dem WLAN-Signal an das Endgerät zu nutzen, um dieses an das Stromnetz zu schalten (einschalten) und auch wieder vollständig zu trennen. Bei Ausführungsbeispielen der Erfindung schaltet der Druckauftrag an einen Drucker, übermittelt über WLAN, somit den Drucker ein. Wenn der Druckauftrag erledigt ist, wird der Drucker wieder vollständig vom Netz getrennt. Unnötiger Standby wird vollständig vermieden.

Im Gegensatz zur DE 10 2005 044 615 A1, bei der es sich bei dem Signal zur Energieübertragung um ein separates, zusätzliches Signal auf einer zusätzlichen Frequenz handelt, wird bei der vorliegenden Erfindung keine zusätzliche Frequenz zum WLAN-Spektrum verwendet.

Bei alternativen Ausführungsbeispielen der Erfindung kann das Schaltelement 40 entsprechend der DE 10 2005 044 615 A1 realisiert werden.

Ferner könnte bei Ausführungsbeispielen der Erfindung das Schaltelement 40 durch einen Thyristor realisiert werden.

Bei weiteren alternativen Ausführungsbeispielen der Erfindung kann der mechanische Schwinger 16 auch direkt schalten, d.h. direkt als Schaltelement dienen.

Bevor im Folgenden weitere alternative Ausführungsbeispiele der Erfindung aufgeführt werden, werden zum besseren Verständnis zunächst die folgenden Betriebszustände der Endgeräte 12 definiert. Im "aus"-Zustand ist das Endgerät 12 nicht mit dem Stromnetz (230 V) verbunden, und der Energieverbrauch beträgt 0 Watt. Im "aktiven Zustand" wird das Endgerät 12 mit dem Stromnetz verbunden; es ist in Empfangsbereitschaft und kann Signale im WLAN-Bereich empfangen. Es wird jedoch nicht in den Bereitschaftsmodus hochgefahren, so dass der Energieverbrauch minimal bleibt. Im "Bereitschaftsmodus" wird das Endgerät 12 mit dem Stromnetz verbunden, und es fährt hoch, so dass es bereit ist, seinen bestimmungsgemäßen Dienst durchzuführen (z.B. Drucken), sobald ihm die zu verarbeitenden Informationen (z.B. über die zu druckenden Seiten) über den WLAN-Kanal 42 gesendet werden. Im Bereitschaftsmodus kann das Endgerät 12 noch weitere Zustände mit unterschiedlichem Energieverbrauch definieren. Am Beispiel des Druckers heißt Bereitschaftsmodus, dass der Drucker im Netzwerk verfügbar ist. Dennoch kann er in einem Energiesparmodus sein (z.B. Druckwerk wird nicht beheizt).

Zu unterscheiden sind ferner zwei prinzipiell unterschiedliche Mechanismen, um die Geräte 12 in den aktivierten Zustand zu versetzen. Im Folgenden stellt der Mechanismus A eine unspezifische Aktivierung alle Endgeräte 12 in den Empfangszustand durch WLAN-Signale dar, während der Mechanismus B eine selektive Aktivierung bestimmter Endgeräte 12 über eine Zeitvariation oder über eine Impuls- oder Frequenzvariation innerhalb der WLAN-Frequenzbreite darstellt. Diese Mechanismen können auf der Hard- und Softwareseite, beispielsweise durch eine Auswertung in Zusammenarbeit mit dem mechanischem Schwinger 16 und per Software für Variante A, eine zeitgesteuerte Auswertung per Software in Zusammenarbeit mit dem mechanischem Schwinger 16 für Variante B oder einen Nano-Zustandsautomaten zur frequenz- und impulsmodulierten Auflösung eines Aktivierungscodes für Variante B umgesetzt werden.

Bei weiteren alternativen Ausführungsbeispielen der Erfindung kann eine Auswertung in Zusammenarbeit mit dem mechanischen Schwinger 16 und per Software für Variante A erfolgen. Hierbei wird über den mechanischen Schwinger 16 sichergestellt, dass nur eine WLAN-Frequenz ein WLAN-Endgerät 12 aktivieren kann. Ein Endgerät 12 wird sich somit nicht auf das Signal z.B. eines Garagentoröffners anschalten. Wenn allerdings mehrere WLAN-Endgeräte 12 ihren mechanischen Schwinger 16 auf dem selben WLAN-Kanal 42 eingestellt haben, dann werden sie gemäß Variante A alle bis zur Empfangsbereitschaft für die WLAN-Signale aktiviert. Dies ist bei dieser Variante gewünscht. Nachdem alle Endgeräte 12 im Netz aktiviert sind, verschickt der WLAN-Zugriffspunkt 10 über das WLAN-Protokoll (z.B. 802.11) eine Nachricht: "Gerät mit WLAN-ID xy: bitte einschalten". Daraufhin wissen alle anderen (nicht-xy) Teilnehmer, dass sie nicht gemeint sind und können sich über das im Vorhergehenden beschriebene Abschaltverhalten über das WLAN-Protokoll wieder abschalten.

Diese Variante A ist zwar am einfachsten zu verwirklichen, hat aber den Nachteil, dass in einer WLAN-Umgebung immer alle Endgeräte 12 kurz aktiviert werden. Dieser Nachteil kann abgemildert werden, indem der WLAN-Zugriffspunkt 10 nur Aktivierungssignale bzw. Aufwecksignale aussendet, wenn in einem Pufferspeicher eine gewisse Menge an zu übertragenden Informationen vorhanden ist, die an eines oder mehrere WLAN-Endgeräte 12 zu verschicken ist.

Bei weiteren alternativen Ausführungsbeispielen der Erfindung kann eine zeitgesteuerte Auswertung per Software in Zusammenarbeit mit dem mechanischen Schwinger 16 für Variante B zur selektiven Aktivierung von Endgeräten 12 erfolgen. Entsprechend der Variante A spricht hierbei der mechanische Schwinger 16 in jedem Endgerät 12 auf Aktivierungssignale im WLAN-Bereich an, die für alle Endgeräte 12 gleich ist. Im Unterschied zur Variante A allerdings können unterschiedliche Geräte 12 mit mechanischen Schwingern 16 ausgebildet sein, die jeweils eine unterschiedliche Trägheit oder Dämpfung aufweisen. Bei trägeren bzw. stärker gedämpften Schwingern 16 dauert es länger, bis die induzierte elektrische Spannung ausreicht, um das Relais 28 zu schalten, um das jeweilige Endgerät 12 zu aktivieren. Wird die Zeit, über die der WLAN-Zugriffspunkt 10 das Aktivierungssignal aussendet, auf jedes Endgerät 12 abgestimmt, können die Endgeräte 12 somit selektiv angesprochen werden (sog. Zeitmultiplex). Durch solch ein Zeitmultiplex kann somit eine einfache zeitliche Auswertung des Aktivierungscodes erfolgen.

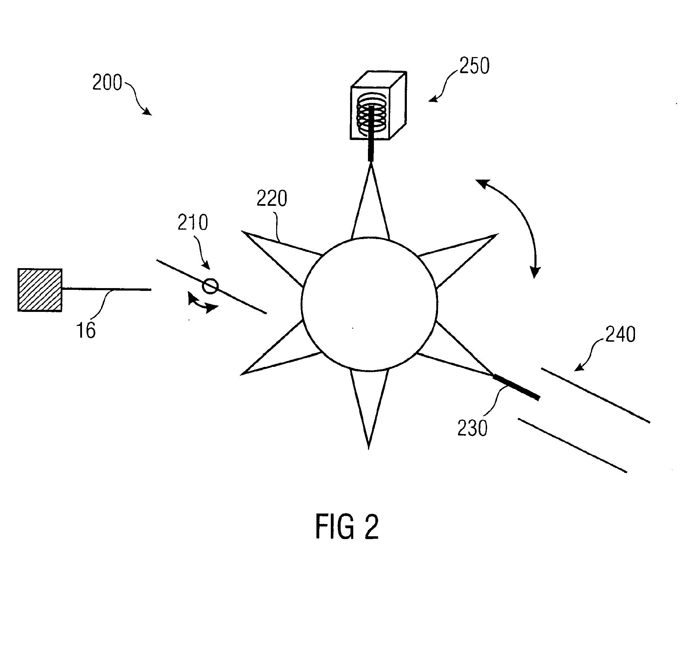

Bei weiteren alternativen Ausführungsbeispielen der Erfindung kann ein Nano-Zustandsautomat 200, wie beispielhaft in Fig. 2 gezeigt, zur frequenz- und impulsmodulierten Auflösung des Aktivierungscodes für Variante B verwendet werden. Der Nachteil bei Variante A ist, dass in einer WLAN-Umgebung immer alle Endgeräte 12 kurz aktiviert werden. Dies lässt sich über Variante B des Aktivierungsmechanismus, wie beispielsweise ein sog. Frequenzmultiplex entschärfen. Jedes Endgerät 12 reagiert auf einen anderen Kanal im WLAN-Band, und es wird von Anfang an nur dasjenige Endgerät 12 angesprochen, das dann auch in den Bereitschaftsmodus (z.B. "Drucken") hochgefahren wird.

Bei weiteren alternativen Ausführungsbeispielen der Erfindung können unterschiedliche Geräte mit jeweils unterschiedlichen mechanischen Schwingern ausgebildet sein, die auf unterschiedliche Frequenzen, d.h. Kanäle (bspw. nahe beieinander liegende Frequenzen), abgestimmt sind. Der WLAN-Zugriffspunkt kann dann für unterschiedliche WLAN-Geräte Aufwecksignale mit unterschiedlichen Frequenzen verwenden, so dass WLAN-Geräte selektiv aufgeweckt bzw. aktiviert werden können. Die Entscheidung, welches Gerät aktiviert wird, kann dadurch im einfachsten Fall über die Frequenz gefällt werden (Frequenzmultiplex).

In anderen Worten, die Identifikation der anzusprechenden WLAN-Endgeräte 12 kann über obiges Frequenzmultiplex realisiert werden.

Eine weitere Möglichkeit besteht darin, ein Protokoll von Impulsen auf dem selben Kanal zu verwenden, wobei z.B. die Anzahl der Impulse dem adressierten Gerät 12 entsprechen. Eine Bedingung dafür ist, dass dieses einfache Protokoll durch ein mechanisches Verfahren ausgewertet bzw. decodiert werden kann.

Bei weiteren alternativen Ausführungsbeispielen der Erfindung kann in diesem Zusammenhang zunächst jeder Impuls über den mechanischen Schwinger 16 nur dann aufgenommen werden, wenn er auf dem richtigen Kanal ankommt, d.h. es findet zunächst eine Selektion der Frequenz über das Resonanzfrequenzprinzip statt. Ferner kann das WLAN-Endgerät 12 beispielsweise eine Mechanik 210 aufweisen, bei der der mechanische Schwinger 16 ausgebildet ist, um bei jedem darauffolgenden Anregen desselben z.B. ein kleines Zahnrad 220 um ein Raster weiterzuschalten. Dieses Zahnrad 220 entspricht somit einem Zustandsautomaten, dessen Position die Anzahl der empfangenen Pulse repräsentiert. Beispielsweise kann an einem der Zähne eine Vorrichtung 230 angebracht sein, die in der richtigen Position einen Schaltkontakt 240 überbrücken kann, was zum Aktivieren bzw. Einschalten des Geräts 12 führt. Bei der richtigen Anzahl von Pulsen wird das entsprechende Endgerät 12 eingeschaltet. Jetzt können zusätzlich zur Frequenz auch über die Menge der Signalpulse Endgeräte 12 adressiert werden. Wenn über das Protokoll mit Hilfe des im Vorhergehenden beschriebenen Abschaltverhaltens der Befehl zum Abschalten an das Gerät 12 geschickt wird, kann beispielsweise über eine Rücksetz-Mechanik 250 das Zahnrad 220 in den Ausgangszustand bzw. den Zustand 0 gebracht werden. Die Auswertung des Aktivierungscodes kann somit auch durch einen Nano-Struktur-Zustandsautomaten erfolgen.

Schließlich könnte bei alternativen Ausführungsbeispielen der Erfindung auf die Schalteinrichtung 22 verzichtet werden, wenn der Empfänger 13 des WLAN-Endgeräts 12 im ausgeschalteten Zustand nur wenig oder keine Energie verbraucht. In anderen Worten, die Schalteinrichtung 22 bzw. Umschaltvorrichtung ist bei alternativen Ausführungsbeispielen technisch gesehen je nach Ausgestaltungsform bzw. Design nicht zwingend nötig.

Die Schalteinrichtung ist besonders vorteilhaft, um Verluste über die Antenne des Geräts zu vermeiden, wenn ein breitbandiges frequenzselektives Bauelement, wie beispielsweise ein breitbandiger (LC-)Schwingkreis, und nicht der mechanische Schwinger verwendet wird.

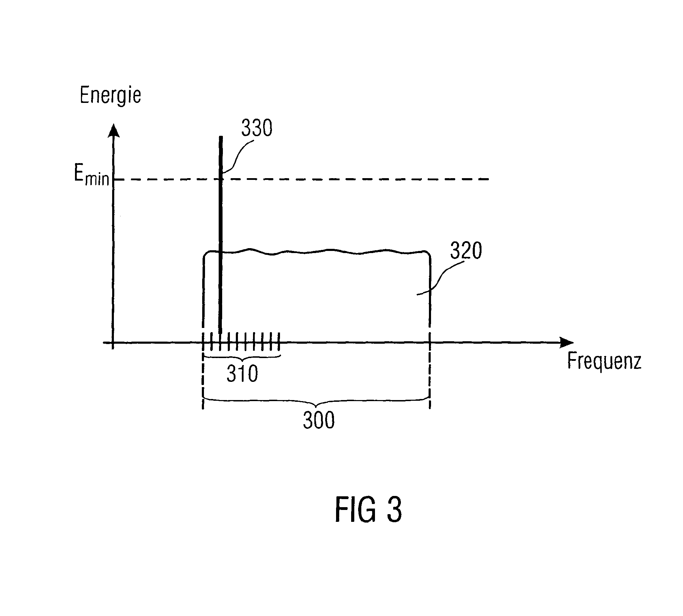

Fig. 3 zeigt ein beispielhaftes WLAN-Spektrum 300, das z.B. 10 Aufweckkanäle 310 und ein entsprechendes Aufwecksignal 330 (bzw. Aufweckimpuls) aufweist. Wie in Fig. 3 gezeigt, findet eine Übertragung von Daten 320 innerhalb des WLAN-Spektrums 300 statt. Das frequenzselektive Bauelement, wie beispielsweise der mechanische Schwinger 16, reagiert nur auf die Frequenzen in den Aufweckkanälen 310. Selbst wenn diese Kanäle auch für die Datenübertragung verwendet werden, ist die durchschnittliche Energie zu gering, um den Aktivierungsmechanismus zu betätigen (d.h. die durchschnittliche Energie liegt unterhalb einer Mindestenergie Eₘᵢₙ). Hierbei ist es natürlich vorteilhaft, in den Aufweckkanälen 310 keine Daten 320 zu schicken.

Das bedeutet, dass der mechanische Schwinger 16 im Betrieb nicht zwingend von der Antenne 24 des WLAN-tauglichen Geräts 12 bzw. vom Hochfrequenz (HF-)Pfad abgekoppelt werden muss (Kontakt 44). Der Grund dafür ist, dass der mechanische Schwinger 16 während der Datenübertragung nicht in Resonanz kommt. Selbst wenn er in Resonanz käme, würde nur ein Aufwecken eines weiteren zweiten Teilnehmers bewirkt werden, während der erste Teilnehmer bereits aktiviert (d.h. im Zustand "an") ist. So ist bei der "Magnetversion", d.h. wenn die Antenne 24 mit dem mechanischen Schwinger 16 verbunden bleibt, bereits sichergestellt, dass der erste Teilnehmer weiterhin anbleibt. Bei der oben beschriebenen Version (Fig. 2) des "Zustandsautomaten" 200 müsste im Zustand "an" lediglich das Zahnrad 220 blockiert sein, um ein unbeabsichtigtes Weiterschalten zu verhindern.

## Patentansprüche

1. Vorrichtung zum Aktivieren eines Geräts (12), mit folgenden Merkmalen:
einem Schaltelement (40); und
einer Einschalteinrichtung (14), die ausgelegt ist, um ein frequenzselektives Bauelement (16) durch ein elektromagnetisches Signal, das über eine Antenne (24) des Geräts (12) empfangen wird, anzuregen, wodurch eine Betätigung des Schaltelements (40) bewirkt wird, um das Gerät (12) mit einer Leistungsversorgung (26) zu verbinden, wobei die Resonanzfrequenz des frequenzselektiven Bauelementes (16) auf die Frequenz des innerhalb eines vorbestimmten Frequenzbereichs übertragenen Signals abgestimmt ist.

2. Vorrichtung nach Anspruch 1, bei der das frequenzselektive Bauelement einen mechanischen Schwinger aufweist.

3. Vorrichtung nach Anspruch 1 oder 2, die eine Schalteinrichtung (22) aufweist, die ausgelegt ist, um die Antenne (24) des Geräts (12) mit dem frequenzselektiven Bauelement (16) zu koppeln, wenn das Gerät (12) nicht mit einer Leistungsversorgung (26) verbunden ist und um die Antenne (24) mit dem Empfänger (13) des Geräts (12) zu koppeln, wenn das Gerät (12) mit der Leistungsversorgung (26) verbunden ist.

4. Vorrichtung nach Anspruch 1 oder 3, bei der das frequenzselektive Bauelement ein mechanischer Schwinger (16) ist, der an einem freien Ende einen Permanentmagneten (18) aufweist, der derart bezüglich einer Induktionsspule (20) angeordnet ist, dass bei einer Bewegung des Permanentmagneten (18) ein Strom in die Induktionsspule (20) induziert wird.

5. Vorrichtung nach einem der Ansprüche 1 bis 4, bei der das Schaltelement (40) geeignet ist, um mit einem kleinen Strom einen großen Strom zu schalten.

6. Vorrichtung nach einem der Ansprüche 1 bis 5, bei der das frequenzselektive Bauelement (16) ausgelegt ist, um das Schaltelement (40) beim Empfang spezieller innerhalb des vorbestimmten Frequenzbereichs übertragener Signale zu betätigen und das Schaltelement (40) beim Empfang von innerhalb des vorbestimmten Frequenzbereichs übertragenen Kommunikationssignale nicht zu betätigen.

7. Vorrichtung nach Anspruch 6, bei der die speziellen Signale Impulse mit einer maximalen möglichen Ausgangsleistung eines WLAN-Zugriffspunkts (10) sind.

8. Vorrichtung nach einem der Ansprüche 1 bis 7, bei der das Gerät (12) ein WLAN-taugliches Gerät ist, wobei der vorbestimmte Frequenzbereich ein WLAN-Kanal ist.

9. Gerät (12) mit einer Vorrichtung nach einem der Ansprüche 1 bis 8.

10. Gerät (12) nach Anspruch 9, das eine Ausschalteinrichtung (50) aufweist, die ausgelegt ist, um das Gerät (12) von der Leistungsversorgung (26) zu trennen, wenn es nicht durch innerhalb des vorbestimmten Frequenzbereichs übertragene Kommunikationssignale angesprochen wird.

11. Verfahren zum Aktivieren eines Geräts (12), mit:
Empfangen eines Signals innerhalb eines vorbestimmten Frequenzbereichs; und
Nutzen von elektromagnetischer Energie aus dem Signal, um ein frequenzselektives Bauelement (16) anzuregen, um ein Schaltelement (40) zu betätigen, um das Gerät (12) mit einer Leistungsversorgung (26) zu verbinden.

12. Verfahren nach Anspruch 11, mit:
Empfangen von Kommunikationssignalen innerhalb des vorbestimmten Frequenzbereichs; und
Trennen des Geräts (12) von der Leistungsversorgung (26), wenn das Gerät (12) nicht von den Kommunikationssignalen angesprochen wird.

13. Verfahren nach einem der Ansprüche 11 oder 12, mit:
Koppeln einer Antenne (24) des Geräts (12) mit einem frequenzselektiven Bauelement (16), wenn das Gerät (12) nicht mit der Leistungsversorgung (26) verbunden ist; und
Koppeln der Antenne (24) des Geräts (12) mit einem Empfänger (13) des Geräts (12), wenn das Gerät (12) mit der Leistungsversorgung (26) verbunden ist.

14. Verfahren nach einem der Ansprüche 11 bis 13, bei dem das Signal über einen WLAN-Kanal empfangen wird.
